# FASCICULE DE BREVET EUROPEEN

(11) **EP 3 510 634 B1**
(45) Date de publication et mention de la délivrance du brevet: **22.03.2023**
(21) Numéro de dépôt: 17780464.8
(22) Date de dépôt: 05.09.2017
(51) Int. Cl.: H01L 21/673

(54) **PROCEDE DE TRANSPORT ET DE STOCKAGE D'UNE PLAQUE SEMICONDUCTRICE EN ENCEINTE HERMETIQUE**
VERFAHREN FÜR DEN TRANSPORT UND DIE LAGERUNG EINER HALBLEITERPLATTE IN EINEM HERMETISCH VERSCHLOSSENEN BEHÄLTNIS
METHOD FOR THE TRANSPORTATION AND STORAGE OF A SEMICONDUCTOR PLATE IN A HERMETIC CONTAINER

(30) Priorité: 07.09.2016 FR 1658300
(43) Date de publication de la demande: 17.07.2019
(73) Titulaire: Centre National de la Recherche Scientifique, 75794 Paris Cedex 16 (FR); Université Grenoble Alpes, 38400 Saint-Martin-d'Hères (FR)
(72) Inventeur: PELISSIER, Bernard, 38130 Echirolles (FR)
(74) Mandataire: Lavoix
(86) Numéro de dépôt international: PCT/FR2017/052340
(87) Numéro de publication internationale: WO 2018/046831

(56) Documents cités:
- JP-A- 2008 202 114
- US-A1- 2007 059 129

## Description

La présente demande de brevet revendique la priorité de la demande de brevet français FR16/58300 qui sera considérée comme faisant partie intégrante de la présente description.

### Domaine

La présente demande concerne un procédé de transport et/ou de stockage d'une plaque semiconductrice en enceinte hermétique.

### Exposé de l'art antérieur

La fabrication de composants microélectroniques sur une plaque semiconductrice comprend de nombreuses étapes mises en oeuvre par divers équipements. Le document JP 2008 202114 porte sur un système qui permet d'optimiser, en termes de coût et d'encombrement au sol, un unique équipement classique de la chaine de procédé en microélectronique : un équipement de dépôt de l'oxyde de grille des transistors, et propose au sein de cet unique équipement d'utiliser un « cluster » multichambres, avec, au moins, une chambre dédiée au dépôt de l'oxyde, une autre chambre dédiée au nettoyage de surface avant dépôt, et toujours au sein du même équipement, une chambre de transfert robotisée est classiquement utilisée pour transférer les plaques de la chambre de dépôt à l'autre chambre dédiée au nettoyage.

Le document US 7418982 divulgue une boite transportant des plaques semiconductrices dans laquelle de l'hydrogène peut être introduit.

Entre deux étapes successives de fabrication, la plaque semiconductrice est transportée d'un équipement à un autre, et peut être stockée pendant une durée allant de quelques heures à plusieurs jours. En effet, les équipements sont situés ou bien en un même lieu, ou bien en des lieux différents, éventuellement sur des continents différents.

On a proposé de transporter et de stocker des plaques semiconductrices dans des boîtes hermétiques afin d'éviter toute contamination ou oxydation de ces plaques. Pour cela, une boîte est couplée hermétiquement à un équipement dans lequel se trouve une plaque à transporter, par l'intermédiaire d'une interface ou sas d'entrée/sortie. La plaque est alors déplacée de l'intérieur de l'équipement jusque dans la boîte, par l'intermédiaire de l'interface. La boîte est ensuite refermée hermétiquement puis découplée de l'interface pour être transportée jusqu'à un équipement suivant au niveau duquel la plaque est transférée de la boîte à l'équipement.

Pour limiter l'oxydation de la plaque semiconductrice, la boîte peut être remplie d'un gaz neutre à la pression ambiante. Toutefois, il est en pratique très difficile de disposer d'un gaz neutre pur à 100%. D'autre part, après certaines étapes réalisées sous vide ou sous basse pression, la surface de la plaque semiconductrice peut être sensible à une augmentation de pression jusqu'à la pression atmosphérique. Il en résulte que des modifications de la surface de la plaque par des phénomènes d'adsorption, de désorption, et/ou de physisorption sont toujours susceptibles de se produire.

Pour s'affranchir des problèmes résultant de la disponibilité d'un gaz neutre pur, un vide peut être établi dans la boîte. Néanmoins, une fois le vide établi, des dégazages peuvent se produire à partir des parois internes de la boîte et de son couvercle ou porte. Notamment, dans le cas où la boîte ou les joints utilisés pour assurer l'herméticité de la boîte sont en des polymères, ces derniers sont susceptibles de dégazer des composés carbonés à l'intérieur de la boîte. Il est donc nécessaire de maintenir le pompage des gaz présents dans la boîte après sa fermeture, et de préférence de maintenir un ultravide, c'est-à-dire une pression dans la boîte inférieure à 10-9 mbars (10-7 Pa). Le maintien d'un tel pompage après fermeture de la boîte nécessite l'utilisation d'équipements peu adaptés au transport de la boîte. De plus, l'utilisation d'un ultravide nécessite de recourir à des technologies coûteuses et difficiles à mettre en oeuvre, telles que des boîtes et/ou des joints métalliques, par exemple des boîtes en acier inoxydable et des joints en cuivre.

### Résumé

Un mode de réalisation prévoit un procédé de transport et/ou de stockage de plaques semiconductrices en enceinte hermétique qui pallie au moins certains des inconvénients des divers procédés susmentionnés.

Un mode de réalisation prévoit un procédé de transport et/ou de stockage d'au moins une plaque semiconductrice, dans lequel la plaque est disposée dans une enceinte hermétique remplie d'hydrogène à une pression comprise entre 10⁻¹ et 4*10³ Pa et éventuellement d'au moins un gaz neutre, la pression totale dans l'enceinte étant comprise entre 10⁻¹ et 5*10⁴ Pa.

Selon un mode de réalisation, le procédé comprend les étapes suivantes :
- coupler hermétiquement l'enceinte à une interface d'entrée/sortie d'un équipement,
- déplacer la plaque semiconductrice depuis l'intérieur de l'équipement jusque dans l'enceinte par l'intermédiaire de l'interface,
- remplir l'enceinte d'hydrogène et éventuellement dudit au moins un gaz neutre, et
- fermer hermétiquement l'enceinte et la découpler de l'interface.

Selon un mode de réalisation, l'enceinte est remplie d'hydrogène et dudit au moins un gaz neutre, la pression d'hydrogène étant comprise entre 10 et 4*10³ Pa et la pression totale étant comprise entre 10 et 10⁴ Pa.

Selon un mode de réalisation, ledit au moins un gaz neutre est choisi dans le groupe comprenant l'argon, l'azote et l'hélium.

Selon un mode de réalisation, l'enceinte est uniquement remplie d'hydrogène à une pression comprise entre 10 et 4*10³ Pa. Un mode de réalisation prévoit une enceinte hermétique de transport et/ou de stockage d'une plaque semiconductrice, caractérisée en ce qu'elle est remplie d'hydrogène à une pression comprise entre 10-1 et 4*10³ Pa et éventuellement d'au moins un gaz neutre, la pression totale dans l'enceinte étant comprise entre 10⁻¹ et 5*10⁴ Pa.

Selon un mode de réalisation, l'enceinte est remplie d'hydrogène et dudit au moins un gaz neutre, la pression d'hydrogène étant comprise entre 10 et 4*10³ Pa et la pression totale étant comprise entre 10 et 10⁴ Pa.

Selon un mode de réalisation, ledit au moins un gaz neutre est choisi dans le groupe comprenant l'argon, l'azote et l'hélium.

Selon un mode de réalisation, l'enceinte est uniquement remplie d'hydrogène à une pression comprise entre 10 et 4*10³ Pa.

Selon un mode de réalisation, l'enceinte est adaptée à être couplée de façon hermétique à une interface d'entrée/sortie d'un équipement de fabrication ou de caractérisation de plaques semiconductrices.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre schématiquement un mode de réalisation d'un procédé de mise en boîte d'une plaque semiconductrice, et un exemple de dispositif permettant la mise en oeuvre de ce procédé ; et
la figure 2 illustre des taux de contamination de la surface d'une plaque semiconductrice en fonction de différentes conditions de stockage de cette plaque.

### Description détaillée

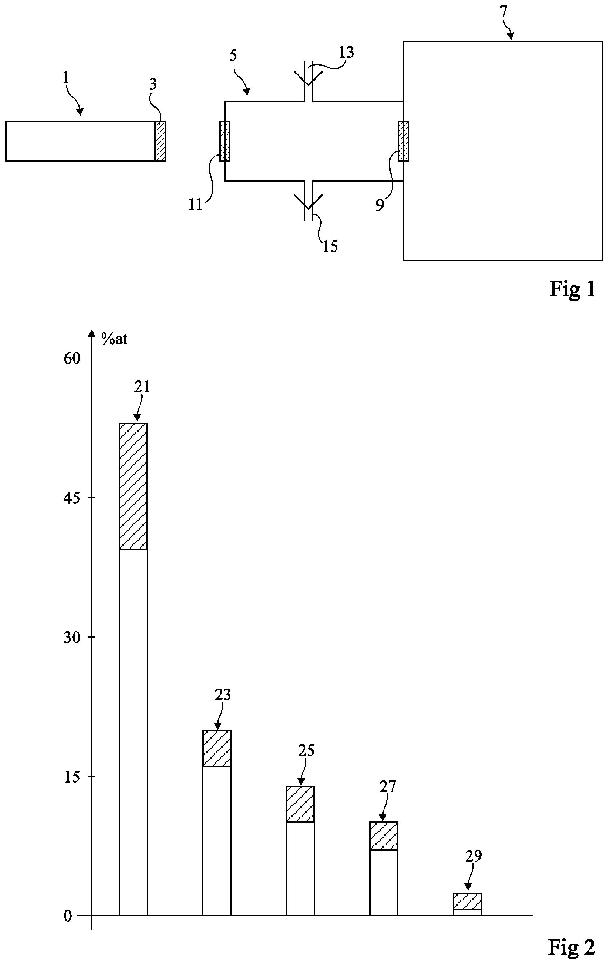

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. Dans ce qui précède, dans la suite de la description et dans les revendications, sauf précision contraire, le terme "sensiblement" signifie à 10 % près, de préférence à 5 % près. L'expression "gaz neutre" signifie gaz qui ne réagit pas avec la surface d'une plaque semiconductrice. L'expression "pression d'un gaz dans une enceinte" signifie pression totale dans l'enceinte lorsque celle-ci n'est remplie qu'avec ce gaz, ou pression partielle de ce gaz dans l'enceinte lorsque celle-ci est remplie d'un mélange de gaz. Le terme "hermétique" signifie ne laissant pas passer les fluides. La figure 1 illustre très schématiquement un dispositif de mise en boîte d'une plaque semiconductrice. La figure 1 illustre une enceinte hermétique ou boîte 1 munie d'une porte 3 fermant hermétiquement la boîte. La boîte 1 peut correspondre à tout type de boîte couramment utilisée dans les chaînes de fabrication de dispositifs microélectroniques, par exemple une boîte de type FOUP (de 15 l'anglais "Front Opening Universal Pod" - réceptacle universel à ouverture frontale), ou de type SMIF (de l'anglais "Standard Mechanical InterFace" - interface mécanique standard). La boîte 1 est adaptée à être couplée hermétiquement à une interface ou sas d'entrée/sortie d'un équipement 7 de fabrication ou de caractérisation de plaques semiconductrices. L'interface 5 comprend une ouverture vers l'intérieur de l'équipement 7, fermée hermétiquement par une porte 9, et une ouverture vers l'extérieur, fermée hermétiquement par une porte 11. L'interface 5 comprend, en outre, des dispositifs d'injection 13 et de pompage 15 de gaz. On peut ainsi transférer une plaque de la boîte 1 à l'équipement et inversement, en toute sécurité, sans polluer ou contaminer la plaque, l'intérieur de la boîte 1 et de l'équipement 7. Une fois la plaque chargée dans la boîte 1, on peut choisir la composition et la pression de l'atmosphère dans la boîte. Bien que cela ne soit pas décrit, des étapes de purge, d'équilibrage de pression, d'ouverture et de fermeture de porte sont effectuées pour transférer une plaque entre la boîte 1 et l'équipement 7. L'homme de l'art sera en mesure d'adapter l'ordre, le nombre et la façon de mettre en oeuvre ces étapes qui dépendent du type de boîte, du type d'interface et du type d'équipement utilisés. On propose ici, lorsqu'une plaque est chargée dans la boîte 1, de remplir la boîte d'hydrogène de sorte que, à sa fermeture, la pression d'hydrogène soit inférieure à 40 mbars (4*103 Pa), par exemple comprise entre 0,001 et 40 mbars (10-1 et 4*103 Pa), de préférence entre 0,1 et 40 mbars (10 et 4*103 Pa). Au moins un gaz neutre choisi dans le groupe comprenant l'argon, l'azote et l'hélium peut être ajouté à l'hydrogène. La boîte 1 est alors remplie de sorte que, à sa fermeture, la pression totale dans la boîte soit comprise entre 0,001 et 500 mbars (10-1 et 5*104 Pa), de préférence entre 0,1 et 100 mbars (10 et 104 Pa). Ainsi, dans ce cas, la pression totale dans la boîte peut être supérieure à 40 mbars (4*103 Pa), 15 tout en conservant une pression partielle d'hydrogène inférieure à 40 mbars (4*103 Pa). L'ajout d'un tel gaz neutre est par exemple prévu en fonction de l'étape mise en oeuvre dans l'équipement 7 ou dans un équipement suivant, notamment pour s'adapter à la pression à l'intérieur des équipements. Comme cela sera décrit plus en détail en relation avec la figure 2, des essais ont montré que, lorsqu'une plaque semiconductrice est mise en boîte hermétique, sous atmosphère contrôlée en hydrogène comme cela a été proposé ci-dessus, l'oxydation par l'oxygène et la contamination carbonée à la surface de cette plaque sont limitées. Ceci est attribué au caractère réducteur et passivant de l'hydrogène. Ces essais ont également montré que l'hydrogène ne modifie pas la structure surfacique de la plaque semiconductrice. Dans une chaîne de production comportant plusieurs équipements 7 munis de leurs interfaces 5, la pression dans les équipements et leurs interfaces est le plus souvent inférieure à la pression ambiante. Du fait que la pression totale dans la boîte 1 est également inférieure à la pression ambiante et peut être adaptée à la pression dans les équipements, les contraintes de pompage sont limitées. De manière avantageuse, la pression totale dans la boîte est comprise dans des plages de pression faciles et peu coûteuses à mettre en oeuvre. En particulier, pour les plages de pression indiquées ci-dessus, la boîte 1, la porte 3 et les joints (non représentés) assurant le couplage hermétique de la boîte 1 avec la porte 3 ou l'interface 5 peuvent être en des polymères peu coûteux. Une pression d'hydrogène dans la boîte 1 inférieure à 40 mbars (4*103 Pa) permet de s'affranchir de tout risque d'inflammabilité de l'hydrogène en cas d'ouverture accidentelle ou de fuite de la boîte 1. La figure 2 illustre le taux de contamination de la surface d'une plaque de silicium après une heure de stockage, sous différentes conditions, dans une boîte hermétique en aluminium avec des joints en un matériau polymère. Le taux de contamination, en ordonnées, est exprimé en pourcentage d'atomes (% at.) d'oxygène et de carbone présents à la surface de la plaque et est représenté par des barres. Pour chaque barre, la partie inférieure non hachurée représente la contamination en atomes de carbone et la partie supérieure hachurée représente la contamination en atomes d'oxygène. Les barres 21 et 23 correspondent au cas où la plaque est stockée sous vide dynamique, à des pressions respectives de 10-6 mbars (10-4 Pa) et 10-7 mbars (10-5 Pa). La barre 25 correspond au cas où la plaque est stockée sous vide statique, à une pression de 10-2 mbars (1 Pa). La barre 27 correspond au cas où la plaque est stockée dans une boîte remplie d'un gaz neutre à basse pression, ici de l'azote à une pression de 80 mbars (8*I05 Pa). La barre 29 correspond au cas où la plaque est stockée dans une boîte, sous atmosphère contrôlée en hydrogène comme cela a été proposé ici. Comme cela se voit sur la figure 2, le stockage d'une plaque semiconductrice sous atmosphère contrôlée en hydrogène (barre 29) permet de diminuer la contamination de la surface de la plaque par des atomes de carbone et d'oxygène par rapport au cas d'un stockage sans hydrogène. Plus particulièrement, dans le cas d'un stockage sous atmosphère contrôlée en hydrogène, la contamination en atomes de carbone est inférieure à 1,4 % at., la contamination en atomes d'oxygène est inférieure à 0,6 % at., et la contamination totale en atomes d'oxygène et de carbone est inférieure à 2 % at.. Ainsi, la contamination en atomes de carbone est au moins dix fois plus faible, la contamination en atomes d'oxygène est au moins deux fois plus faible, et la contamination totale en atomes d'oxygène et de carbone est au moins cinq fois plus faible dans le cas d'un stockage sous atmosphère contrôlée en hydrogène par rapport au cas d'un stockage sans hydrogène. Des modes de réalisation particuliers ont été décrits. Diverses variantes et modifications apparaîtront à l'homme de l'art. En particulier, plusieurs plaques semiconductrices peuvent être transportées ou stockées dans une même boîte ou enceinte hermétique, sous atmosphère contrôlée en hydrogène comme cela est proposé ici. Des dispositifs d'injection et de pompage de gaz peuvent être périodiquement couplés à la boîte pour entretenir une atmosphère contrôlée en hydrogène dans la boîte une fois celle-ci découplée de toute interface d'entrée/sortie d'un équipement, par exemple lors de longues étapes de stockage et/ou de transport s'étendant sur plusieurs jours.

## Revendications

1. Procédé de transport et/ou de stockage d'au moins une plaque semiconductrice, dans lequel la plaque est disposée dans une boite transportable comprenant une enceinte hermétique (1) de transport et/ou de stockage propre à être couplée/découplée d'une interface d'entrée/sortie (5) d'un équipement (7), **caractérisé en ce que** la boite transportable comprenant l'enceinte hermétique (1) de transport et/ou de stockage est remplie d'hydrogène à une pression comprise entre 10⁻¹ et 4*10³ Pa.

2. Procédé selon la revendication 1, dans lequel l'enceinte comprend en outre au moins un gaz neutre, la pression totale dans l'enceinte étant comprise entre 10⁻¹ et 5*10⁴ Pa.

3. Procédé selon la revendication 2, comprenant les étapes suivantes :
- coupler hermétiquement l'enceinte (1) à une interface d'entrée/sortie (5) d'un équipement (7),
- déplacer la plaque semiconductrice depuis l'intérieur de l'équipement (7) jusque dans l'enceinte (1) par l'intermédiaire de l'interface (5),
- remplir l'enceinte (1) d'hydrogène et éventuellement dudit au moins un gaz neutre, et
- fermer hermétiquement l'enceinte (1) et la découpler de l'interface.

4. Procédé selon la revendication 2 ou 3, dans lequel l'enceinte est remplie d'hydrogène et dudit au moins un gaz neutre, la pression d'hydrogène étant comprise entre 10 et 4*10³ Pa et la pression totale étant comprise entre 10 et 10⁴ Pa.

5. Procédé selon l'une quelconque des revendications 2 à 4, dans lequel ledit au moins un gaz neutre est choisi dans le groupe comprenant l'argon, l'azote et l'hélium.

## Patentansprüche

1. Verfahren zum Transport und/oder zur Lagerung mindestens einer Halbleiterplatte, wobei die Platte in einer transportablen Box angeordnet ist, umfassend einen hermetischen Transport- und/oder Lagerbereich (1), der geeignet ist, mit einer Eingangs-/Ausgangsschnittstelle (5) einer Ausrüstung (7) gekoppelt/entkoppelt zu werden, **dadurch gekennzeichnet, dass** die transportable Box, umfassend den hermetischen Transport- und/oder Lagerbereich (1), mit Wasserstoff bei einem Druck zwischen 10⁻¹ und 4*10³ Pa gefüllt ist.

2. Verfahren nach Anspruch 1, wobei der Bereich ferner mindestens ein neutrales Gas umfasst, wobei der Gesamtdruck in der Kammer zwischen 10⁻¹ und 5*10⁴ Pa ist.

3. Verfahren nach Anspruch 2, umfassend die folgenden Schritte:
- hermetisches Koppeln des Gehäuses (1) an eine Ein-/Ausgabeschnittstelle (5) einer Ausrüstung (7),
- Bewegen der Halbleiterplatte aus dem Inneren der Ausrüstung (7) mittels der Schnittstelle (5) bis in dem Gehäuse (1),
- Füllen des Gehäuses (1) mit Wasserstoff und eventuell dem mindestens ein neutrales Gas, und
- hermetisches Schließen des Gehäuses (1) und deren Entkoppeln von der Schnittstelle.

4. Verfahren nach Anspruch 2 oder 3, wobei der Bereich mit Wasserstoff und dem mindestens einen neutralen Gas gefüllt ist, wobei der Wasserstoffdruck zwischen 10 und 4*10³ Pa ist und der Gesamtdruck zwischen 10 und 10⁴ Pa ist.

5. Verfahren nach einem der Ansprüche 2 bis 4, wobei das mindestens eine neutrale Gas ausgewählt ist aus der Gruppe, bestehend aus Argon, Stickstoff und Helium.

## Claims

1. Method of transporting and/or storing at least one semiconductor plate, wherein the plate is arranged in a transportable box comprising an hermetic container (1) of transport and/or storage suitable to be coupled/decoupled from an input/output interface (5) of a piece of equipment (7) **characterized in that** the transportable box comprising an hermetic container (1) of transport and/or storage is filled with hydrogen at a pressure of between 10⁻¹ and 4*10³ Pa.

2. Method according to claim 1, wherein the container further comprises at least one neutral gas, the total pressure in the container being between 10⁻¹ and 5*10⁴ Pa.

3. Method according to claim 2, comprising the following steps of:
- hermetically coupling the container (1) to an input/output interface (5) of a piece of equipment (7),
- moving the semiconductor plate from the inside of the piece of equipment (7) into the container (1) via the interface (5),
- filling the container (1) with hydrogen and, optionally, the at least one neutral gas, and
- hermetically sealing the container (1) and uncoupling it from the interface.

4. Method according to claim 2 or 3, wherein the container is filled with hydrogen and the at least one neutral gas, the hydrogen pressure being between 10 and 4*10³ Pa and the total pressure being between 10 to 10⁴ Pa.

5. Method according to any one of the claims 2 to 4, wherein the at least one neutral gas is selected from the group consisting of argon, nitrogen and helium.
